(19) Europäisches Patentamt / European Patent Office / Office européen des brevets

(11) **EP 2 636 145 B1**

(12) **EUROPEAN PATENT SPECIFICATION**

(45) Date of publication and mention
of the grant of the patent:
**06.04.2016 Bulletin 2016/14**

(51) Int Cl.:
***H03B 5/12*** *(2006.01)*

(21) Application number: **10776637.0**

(86) International application number:
**PCT/EP2010/066564**

(22) Date of filing: **01.11.2010**

(87) International publication number:
**WO 2012/059120 (10.05.2012 Gazette 2012/19)**

(54) **AN OSCILLATOR CIRCUIT WITH FEEDBACK**

OSZILLATORSCHALTUNG MIT RÜCKKOPPLUNG

CIRCUIT OSCILLATEUR À RETOUR D'INFORMATIONS

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**11.09.2013 Bulletin 2013/37**

(73) Proprietor: **Telefonaktiebolaget LM Ericsson
(publ)
164 83 Stockholm (SE)**

(72) Inventor: **BAO, Mingquan
S-426 54 Västra Frölunda (SE)**

(74) Representative: **Ericsson
Patent Development
Torshamnsgatan 21-23
164 80 Stockholm (SE)**

(56) References cited:
**WO-A1-2006/035372      GB-A- 2 453 046
US-A1- 2004 130 369      US-A1- 2009 289 732**

## Description

TECHNICAL FIELD

The present invention discloses an oscillator circuit with feedback.

BACKGROUND

With increases in data communication rates, the performance requirements for oscillator circuits which comprise voltage controlled oscillators, VCOs, also increase. Usually, low phase noise and small variations of the phase noise over a wide-tuning range are among the desired properties of an oscillator circuit with a VCO.

Document WO 2006/035372 A1 discloses an oscillation loop with three switchable amplifiers which can be controlled to form part of the oscillation loop or not, using control signals.

SUMMARY

It is a purpose of the present invention to obtain an oscillator circuit with a VCO with low phase noise and small variations of the phase noise over a wide-tuning range. Such a circuit is disclosed here by means of an oscillator circuit which comprises a Voltage Controlled Oscillator, a VCO, in which the VCO comprises a resonator which is coupled to a first amplifier.

In the oscillator circuit, an output signal from the resonator of the VCO is arranged to be the output signal from the VCO, and the oscillator circuit also comprises a second amplifier which is connected to receive the output signal from the VCO. The output signal of the second amplifier is arranged to be the output signal from the oscillator circuit, and the second amplifier is arranged to provide the VCO with a feedback signal which is in phase with the phase of the output signal from the VCO.

In addition, the second amplifier is arranged to have an amplifier gain seen as a function of frequency which is such that the amplitude of the output signal from the oscillator circuit is constant over an operational range of the oscillator circuit. This can also be seen as giving the second amplifier a gain function which "counteracts" amplitude variations over frequency in the output signal from the VCO.

In one embodiment of the oscillator circuit, the second amplifier is arranged to provide the VCO with its feedback signal to the resonator of the VCO, i.e. the feedback signal is connected to the resonator of the VCO.

In one embodiment of the oscillator circuit, the oscillator circuit comprises a first coupler via which the feedback signal from the amplifier is connected to the VCO, the first coupler being arranged to keep the phase of the feedback signal from the second amplifier to the VCO in phase with the output signal from the VCO.

In one embodiment of the oscillator circuit, the oscillator circuit is provided with a second coupler via which the second amplifier is connected to receive the output signal from the VCO, and the second coupler is arranged to control the power of the output signal from the VCO to the second amplifier.

BRIEF DESCRIPTION OF THE DRAWINGS

The invention will be described in more detail in the following, with reference to the appended drawings, in which

Figs 1-3 show schematic block diagram of various embodiments of the invention, and
Fig 4 shows a more detailed circuit diagram of an embodiment of the invention, and
Figs 5a and 5b show a component of the embodiment of fig 4 and its performance, and
Figs 6-8 show various characteristics of the embodiment of fig 4, and
Fig 9 shows a detailed circuit diagram of another embodiment of the invention.

DETAILED DESCRIPTION

Embodiments of the present invention will be described more fully hereinafter with reference to the accompanying drawings, in which embodiments of the invention are shown. The invention may, however, be embodied in many different forms and should not be construed as being limited to the embodiments set forth herein. Like numbers in the drawings refer to like elements throughout.

The terminology used herein is for the purpose of describing particular embodiments only, and is not intended to limit the invention.

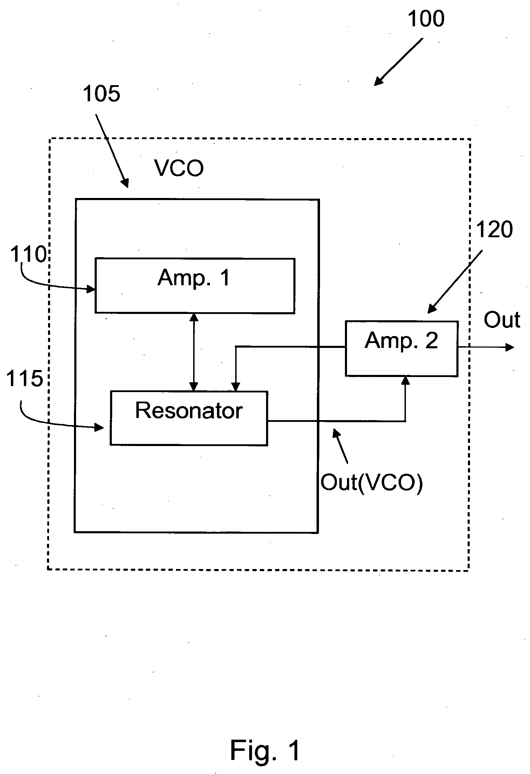

Fig 1 shows a block diagram of an embodiment 100 of the oscillator circuit of the invention which will be described below in order to illustrate some principles used by the invention. Examples which show more detailed designs of the various blocks comprised in the oscillator circuit 100 will be shown later in this text and in other appended drawings.

As can be seen, in the oscillator circuit 100, there is comprised a Voltage Controlled Oscillator, a VCO 105, which in turn comprises a first amplifier 110 coupled to a resonator 115.

The first amplifier 110 and the resonator 115 are connected to each other and interact to cause the Voltage Controlled Oscillator 105 to produce an output signal at an oscillation frequency which is controllable, usually by means of a control voltage. This control voltage is not explicitly shown in fig 1, but will be elaborated upon later in this text. However, the control voltage is usually applied to one or more so called varactors within the resonator. The capacitance of the varactor is altered by means of the control voltage, thereby altering the oscillation frequency of the resonator, which also alters the frequency of the output signal from the resonator.

In the oscillator circuit 100, the output signal from the resonator 115 is used as the output signal from the VCO 105. As can be seen in fig 1, the oscillator circuit 100 also comprises a second amplifier 120, connected to receive the output signal of the VCO 105 as its input signal. In addition, the output signal from the second amplifier 120, i.e. the amplified output signal from the VCO 105, is used as the output signal from the oscillation circuit 100. However, the second amplifier 120 serves not only to amplify the input signal from the VCO, but is also arranged to perform additional purposes: the second amplifier 120 is, as shown in fig 1, arranged to provide the VCO 105 with a feedback signal, with the feedback signal being in phase with the phase of the output signal from the VCO. In addition, the second amplifier 120 is also arranged to have an amplifier gain as a function of frequency which is such that the amplitude of the output signal from the oscillator circuit is constant over an operational range of the oscillator circuit. This is accomplished by means of varying the second amplifier's gain as a function of frequency. Examples of how this is accomplished will be shown later in this text.

Suitably, as shown in fig 1, the feedback signal from the second amplifier 120 to the VCO 105 is provided to the resonator 115 of the VCO.

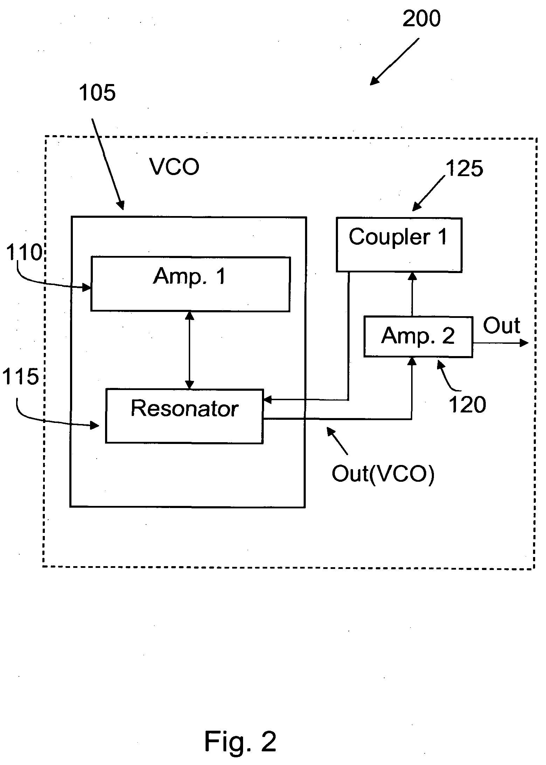

In addition, in an alternative embodiment 200, shown in fig 2, the second amplifier 120 is provided with a first coupler 125 via which the feedback signal from the amplifier is connected to the VCO. A function of this first coupler 125 is that it is arranged to keep the phase of the feedback signal from the second amplifier 120 to the VCO 100 in phase with the output signal from the VCO 100, as an alternative to letting this be a function of the second amplifier 120 as such. Thus, either a coupler such as the one 125 or circuits within the second amplifier 120 itself are used to keep the phase of the feedback signal to the VCO 105 in phase with the output signal from the VCO 105.

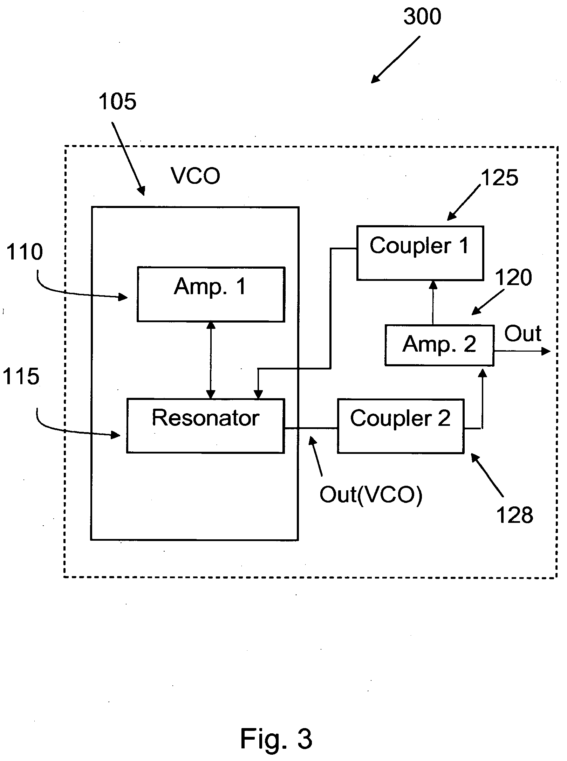

In another embodiment 300, shown in fig 3, the amplifier 120 is provided with both the first coupler 125 of fig 2 and a second coupler 128, via which the amplifier 120 is connected to receive the output signal from the VCO, with the second coupler 128 also being arranged to control the power of the signal from the VCO 105 to the second amplifier 120. In similarity to the first coupler 125, the second coupler 128 is an alternative to comprising the corresponding functions in the second amplifier 120 as such. Thus, either a coupler such as the one 128 or the second amplifier 120 itself are used to receive the output signal from the VCO, and to control the power of the signal from the VCO 105 to the second amplifier 120

Turning now to some more detailed examples of embodiments of an oscillator circuit of the invention, in which the reference numbers 105 and 120 will be used to shown the VCO and the second amplifier of figs 1-3, fig 4 shows a first such detailed embodiment 400: the first amplifier, corresponding to that as 110 in figs 1-3, in this embodiment comprises a first 401 and a second 402 transistor, here shown as bipolar junction transistors although FET-transistors can also be employed. The transistors are connected to each other via their bases, and this connection is AC grounded via a resistor 403, at which a bias voltage $V_b$ for the bases of the transistors 401, 402, can also be applied. In addition, between the emitter and collector of each of the transistors, there is a capacitor 404, 405, suitably with equal capacitances. The emitters of the transistors are connected to ground via respective resistors 406, 407, suitably of equal resistances. The capacitors 404 and 405 are also comprised in the first amplifier, shown as 110 in figs 1-3.

The resonator, shown as 115 in figs 1-3, of the embodiment 400 comprises an "LC"-circuit, i.e. in this case two inductors 408, 409, of equal inductances coupled to each other and AC grounded in the middle, where the inductances are coupled in parallel with two varactors 410, 411 in series with each other. Between the inductors 408, 409 there is a port for a DC supply voltage Vc to the collectors of the transistors 401, 402, and between the varactors 410, 411, there is a port for a control voltage $V_{tune}$ which is used for altering the resonance frequency of the LC circuit and thereby that of the VCO 105.

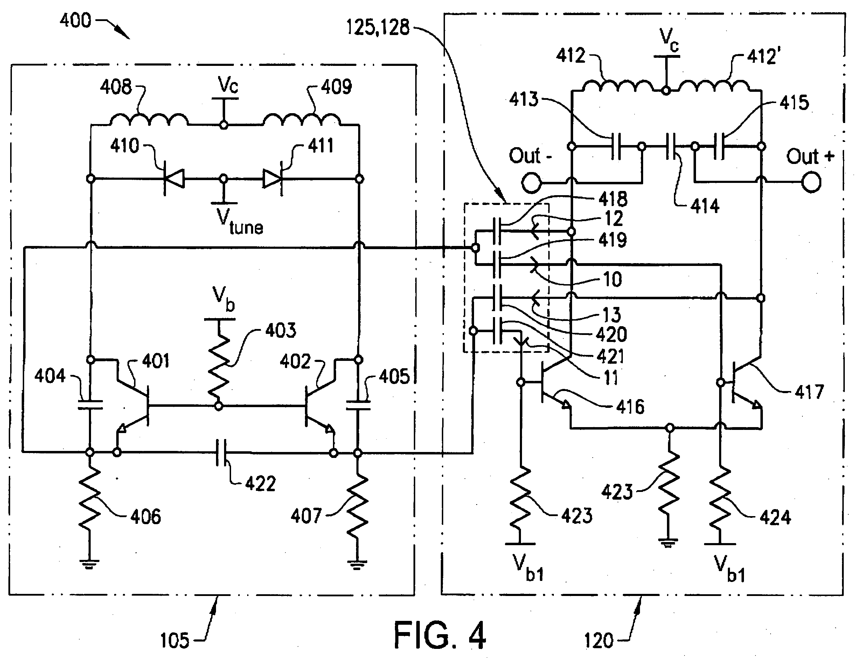

As shown in fig 4, the resonator is connected in parallel with the first amplifier. The resonator and the first amplifier can also be said to form a conventional VCO 105, in this case a so called Colpitts VCO.

The second amplifier 120 in the embodiment 400 also comprises an LC resonator which in turn comprises an inductor 412 (grounded at Vc), in parallel with three serially connected capacitors 413, 414 and 415. The LC resonator of the second amplifier 120 is connected in parallel with an emitter coupled pair of bipolar junction transistors 416, 417. The output signals, i.e. differential output signals with a phase difference of 180 degrees between them, of the oscillator circuit 100 is at the connecting point between the capacitors 413 and 414, as well as the connecting point between capacitor 414 and 415.

In addition, the oscillator circuit 400 comprises two couplers: A coupler consisting of capacitors 418 and 420 corresponds to the first coupler 125 of fig 2, and an additional coupler which corresponds to the second coupler 128 of fig 3, consisting of capacitors 419 and 421, and which serves as the connection which connects the output signal of the VCO 105 to the second amplifier 120. The reason for using capacitors 419, 421, i.e. the second coupler, for this purpose, is that the power which is transferred to the second amplifier can be limited or controlled in this way, by means of dimensioning the capacitors.

Output signals from the VCO 105 are taken from the emitters of the transistors 401 and 402, and are added at input of the second amplifier 120, i.e., the bases of transistors 416, 417 via the capacitors 419 and 421. The output signals from the second amplifier 120 are taken from the collectors of the transistors 416, 417 and are added at the emitters of transistors 401, 402 via capacitors 418 and 420. The capacitances of capacitors 418 to 421 are selected based on the desired output power from the amplifier and the desired amplitude of the feedback signal.

A principle which should be noted in the embodiment 400 shown in fig 4 is that the VCO 105 and second amplifier 120 should be connected so that a positive feedback is obtained for the VCO 105, i.e. so that the feedback signals from the second amplifier 120 and the output signals from the VCO 105 signals are in phase, so as not to degrade the VCO's phase noise.

In the embodiment 400, positive feedback is established based on the factors that at the emitters of transistors 401 and 402, the signals run at 180-anti-phase, i.e. have a phase difference of 180 degrees between them, as do the signals at the base and at the collector of transistors 416, 417 in the second amplifier 120. Therefore, the base of one of the transistors, 416/417 at the amplifier is connected with the emitter of one of the transistors, 401/402, at the VCO via one of the capacitors 419/421 while the collector of the transistor, 416/417, at the amplifier is connected to the emitter of the other transistor 401, 402 via the other of the capacitors 418/420, as shown in fig. 4.

As mentioned above in connection with the description of the embodiments of figs 1-3, a further property of the second amplifier 120 is that it is also arranged to have an amplifier gain as a function of frequency which is such that the amplitude of the output signal from the oscillator circuit 400 is constant over an operational frequency range of the oscillator circuit, i.e. the gain of the amplifier should decrease with frequency as the VCO's 105 output power increases with frequency. This is accomplished in the following way in the embodiment 400:

As shown in fig 4, an LC resonator consisting of inductor 412 and capacitors 413, 414 and 415 is located between the collectors of the transistors 416 and 417. The impedance of this LC resonator controls the gain of amplifier, so that the greater the impedance of the LC resonator, the higher the gain of the amplifier. An equivalent circuit of the LC resonator is shown in 5a, and the corresponding impedance is shown in 5b, where $C_{total}$ represents the total capacitance in the resonator, and R represents the losses of the capacitors and the inductor as well as possible loading from outside resistors.

For an LC resonator such as the one in fig 4, the quality factor Q of the resonator is $Q=R/(\omega L_t)$, where R is the maximum impedance of the LC, Lt is the total inductance in the resonator, the resonance frequency $f_r$ of the LC resonator is $f_r = \dfrac{1}{2\pi\sqrt{L_t C_{total}}}$, and the 3dB bandwidth of the LC resonator is $\Delta f = f_r/Q$, and $C_{total}$ is the total capacitance of the capacitors in the LC resonator

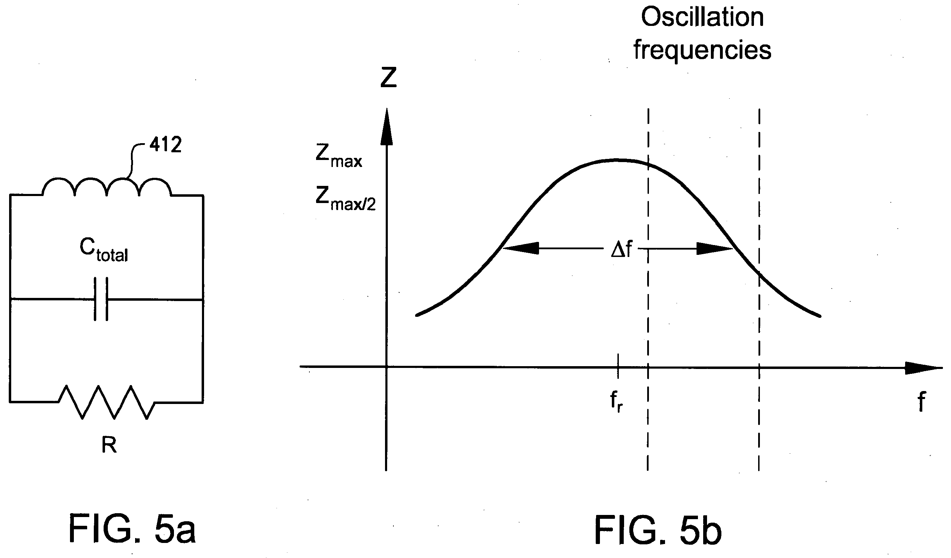

The inductance, $L_t$ and the capacitance $C_{total}$ are chosen so that $f_r$ is less than the VCO's highest oscillation frequency, which will have as a consequence that the impedance of the resonator decreases with the frequencies, as shown in fig 5b.

The variations of the LC resonator's impedance can be selected by changing the 3dB bandwidth, $\Delta f$, for example namely, by changing the equivalent resistance, R. One approach to change R is using an LC resonator such as the one shown in fig 4, and to vary the ratio of the capacitances of the capacitors 413 and 414, where capacitance 413 and 415 are equal. The equivalent resistance R due to external loads is approximately given by the expression:

$$R \approx \left(\frac{C_{413}+2C_{414}}{C_{413}}\right)^2 R_{load} \qquad (1)$$

Here, an external load of 50 Ω is assumed, although not shown in fig 4.

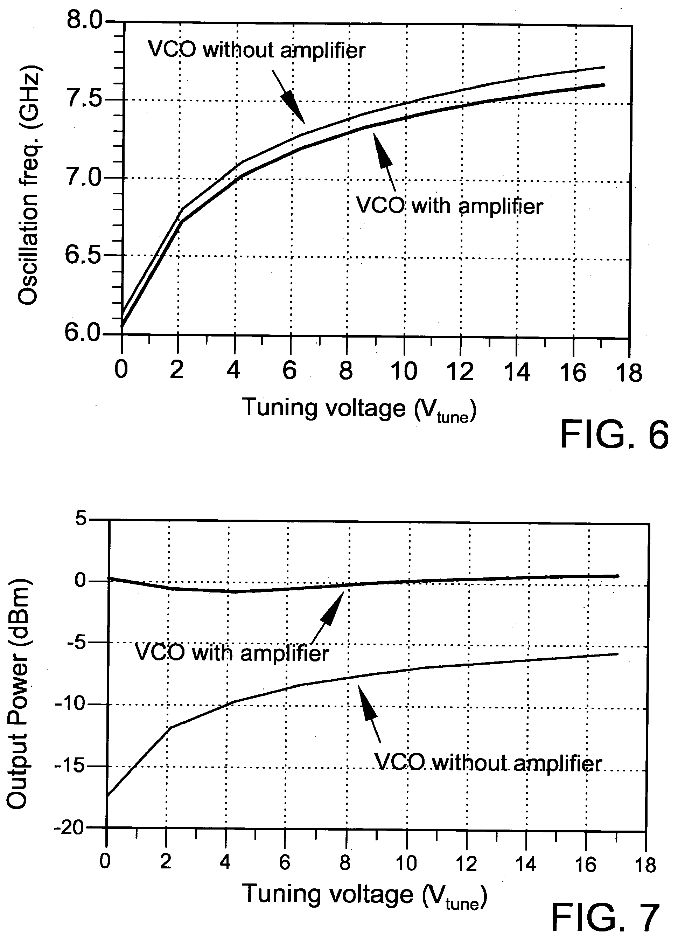

The circuit 400 shown in fig 4 has been realized in InGaP/GaAs HBT (Heterojunction Bipolar Transistor) technology, and has been measured as having oscillation frequencies from 6 to 7.6 GHz, as shown in fig 6, and to have approximately 21% relative tuning range, where the oscillation frequencies increase with the tuning voltage $V_{TUNE}$ of fig 4.

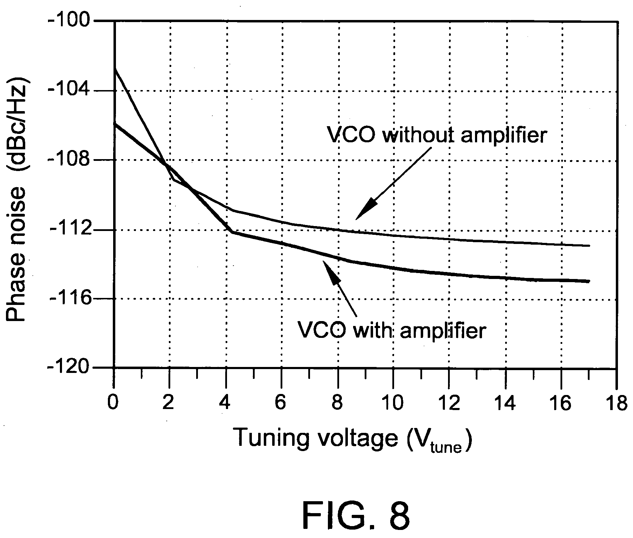

Fig 7 shows the output power for the VCO 105 of the design in fig 4 with and without the second amplifier 120. We seen that for a VCO without an amplifier, the output power varies as much as 12 dBm, while for a VCO with the second amplifier 120, the output power varies less than 1.5 dBm. Moreover, as shown in fig 8, phase noise is reduced by means of the second amplifier 120; especially at the low-end of the tuning range, 3 dBc/Hz phase noise reduction is achieved, while a phase noise reduction of about 2 dBc/Hz is obtained at the upper-end of the tuning range.

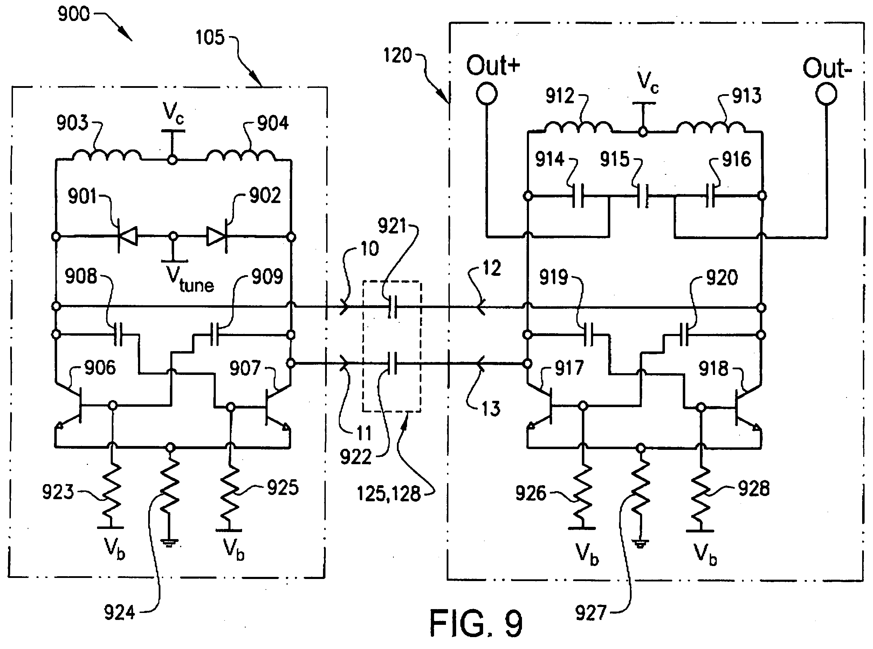

Fig 9 shows a further example 900 of an embodiment of an oscillator circuit which uses the principles of a VCO 105 and a feedback amplifier 120, where the feedback amplifier 120 is connected to the VCO 105 by means of a coupler which is arranged to keep the phase of the feedback signal from the amplifier to the VCO in phase with the output signal from the VCO as well as to control the power of the feedback signal to the VCO 105. In other words, in this embodiment, one coupler incorporates the functions of the two couplers shown previously.

In the embodiment 900, the resonator (shown as 115 in figs 1-3) comprises an LC circuit which has two varactors 901, 902, connected in series to each other and connected in parallel with two serially connected inductors 903, 904, with a port for a bias voltage $V_c$ being located between the inductors 903, 904.

The first amplifier (shown as 100 in figs 1-3) of the embodiment 900 comprises two transistors, 906, 907, here shown as bipolar junction transistors, although FET transistors can also be used. The base of each transistor 906, 907 is connected to the collector of the other transistor via respective capacitors (suitably of equal capacitance) 908, 909, which are also comprised in the first amplifier. The first amplifier and the resonator of the VCO 105 are connected in parallel to each other.

In the embodiment 900, the second amplifier 920 consists of an LC resonator which comprises two serially connected inductances 912 and 913, with a DC bias feed point $V_c$ between them, in parallel with three serially connected capacitors 914, 915, 916, of equal capacitances, and an emitter coupled transistor pair 917, 918, which is cross-coupled via (equally large) capacitors 919, 920.

The coupler between the feedback amplifier 920 and the VCO 905 consists of two equally sized capacitors 921, 922, which fulfill the function of the first and second couplers 125, 128 of fig 3. These capacitors can either be seen as a separate coupler, or can be comprised in the second amplifier 120.

The VCO's output signals are taken from the collectors of the transistors 906, 907 and are added at the input of the amplifier 920, i.e., the bases of the transistors 917, 918 via the capacitors 919, 920. The output signals from the second amplifier 120 are taken from the collectors of the transistors 917, 918, and are added at the bases of the transistors 906, 907 via the capacitors 908, 909. The capacitance of the capacitors 921, 922 is selected based on the desired amplifier output power and the desired intensity of the feedback signal.

Also, the input/output of the VCO 105 and the amplifier 120 should be connected so that a positive feedback is obtained, i.e. so that the feedback signals and VCO signals are in-phase, in order to avoid degradation of the VCO's phase noise.

In the embodiment 900, positive feedback is obtained by virtue of the fact that at the collectors of the transistors 906, 907, the signals are at "180-antiphase", i.e. have a phase difference of 180 degrees between them, which is also the case for the signals at the base and at the collector of transistors 917, 918 in the amplifier 920. Therefore, the base of one of the transistors 917, 918 in the amplifier is connected to the collector of one of the transistors 906, 907 in the VCO, while the collector of the transistor 917, 918 in the amplifier should be connected to the base of other of the transistors 906, 907, via a capacitor 921, 922 in the coupler.

In the drawings and specification, there have been disclosed exemplary embodiments of the invention. However, many variations and modifications can be made to these embodiments without substantially departing from the principles of the present invention. Accordingly, although specific terms are employed, they are used in a generic and descriptive sense only and not for purposes of limitation.

The invention is not limited to the examples of embodiments described above and shown in the drawings, but may be freely varied within the scope of the appended claims.

## Claims

1. An oscillator circuit (100) comprising a Voltage Controlled Oscillator, a VCO (105), the VCO comprising a resonator (115) coupled to a first amplifier (110), with an output signal (10, 11) from the resonator (115) being arranged to be the output signal from the VCO, the oscillator circuit (100) also comprising a second amplifier (120) connected to receive the output signal (10, 11) from the VCO, with the output signal of the second amplifier (120) being arranged to be the output signal from the oscillator circuit, the oscillator circuit (100) being **characterized in that** the second amplifier is arranged to provide the VCO with a feedback signal (12, 13) which is in phase with the phase of the output signal from the VCO, and **in that** the second amplifier (120) comprise reative elements to create an amplifier gain as a function of frequency which is such that the amplitude of the output signal from the oscillator circuit (100) is constant over an operational frequency range of the oscillator circuit, with the second amplifier (120) being arranged to provide the VCO (105) with said feedback signal (12, 13) to the resonator (115) of the VCO.

2. The oscillator circuit (100) of claim 1, in which the second amplifier (120) comprises a first coupler (125), the first coupler (125) being arranged to keep the phase of the feedback signal (12, 13) from the second amplifier (120) to the VCO (105) in phase with the output signal from the VCO (105).

3. The oscillator circuit (100) of claim 1 or 2, comprising a second coupler (128), via which the second amplifier (120) is connected to receive the output signal (10, 11) from the VCO, said second coupler (128) being arranged to control the power of the output signal (10, 11) from the VCO (105) to the second amplifier (120).

4. The oscillator circuit (100) of any of claims 1-3, in which the VCO (105) is a Colpitts VCO.

5. The oscillator circuit (100) of any of claims 1-3, in which the VCO (105) is a cross-coupled VCO.

## Patentansprüche

1. Eine Oszillator-Schaltung (100) umfassend einen spannungsgesteuerten Oszillator [VCO] (105), der einen Resonator (115) umfasst, gekoppelt an einen ersten Verstärker (110), mit einem Ausgangssignal (10, 11) vom Resonator (115), so eingerichtet, dass es das Ausgangssignal des VCO ist, die Oszillator-Schaltung (100) umfasst auch einen zweiten Verstärker (120), angeschlossen um das Ausgangssignal (10, 11) vom VCO zu empfangen, das Ausgangssignal des zweiten Verstärkers (120) ist so eingerichtet, dass es das Ausgangssignal der Oszillator-Schaltung bildet, die Oszillator- Schaltung (100) ist **dadurch gekennzeichnet, dass** der zweite Verstärker vorgesehen ist, um den VCO mit einem Rückkopplungssignal (12, 13) zu versorgen, das phasengleich mit der Phase des Ausgangssignals des VCO ist, und dadurch, dass der zweite Verstärker (120) reaktive Elemente enthält, um einen Verstärkungsfaktor zu erzeugen, als Funktion der Frequenz, in einer Art, dass die Amplitude des Ausgangssignals von der Oszillator-Schaltung (100) über einen operationellen Frequenzbereichs der Oszillator-Schaltung konstant ist, wobei der zweite Verstärker (120) eingerichtet ist, den VCO (105) mit dem genannten Rückkopplungssignal (12, 13) an den Resonator (115) des VCO zu versorgen.

2.  Die Oszillator-Schaltung (100) nach Anspruch 1, worin der zweite Verstärker (120) einen ersten Koppler (125) umfasst, dieser erste Koppler (125) ist vorgesehen, um die Phase des Rückkopplungssignal (12, 13) vom zweiten Verstärker (120) an den VCO (105) in Phase mit dem Ausgangssignal vom VCO (105) zu halten.

3.  Die Oszillator-Schaltung (100) nach Anspruch 1 oder 2, die einen zweiten Koppler (128) umfasst, über den der zweite Verstärker (120) angeschlossen wird, um das Rückkopplungssignal (10, 11) vom VCO zu empfangen, dieser zweite Koppler (128) ist vorgesehen, um die Stärke des Ausgangssignals (10, 11) vom VCO (105) an den zweiten Verstärker (120) zu kontrollieren.

4.  Die Oszillator-Schaltung (100) nach irgendeinem der Ansprüche 1-3, worin der VCO (105) ein Colpitts VCO ist.

5.  Die Oszillator-Schaltung (100) nach irgendeinem der Ansprüche 1-3, worin der VCO (105) ein kreuzgekoppelter VCO ist.

**Revendications**

1.  Circuit oscillant (100) comprenant un Oscillateur Commandé en Tension, un VCO (105), le VCO comprenant un résonateur (115) couplé à un premier amplificateur (110), un signal de sortie (10, 11) provenant du résonateur (115) étant agencé pour être le signal de sortie provenant du VCO, le circuit oscillant (100) comprenant également un second amplificateur (120) connecté pour recevoir le signal de sortie (10, 11) provenant du VCO, le signal de sortie du second amplificateur (120) étant agencé pour être le signal de sortie provenant du circuit oscillant, le circuit oscillant (100) étant **caractérisé en ce que** le second amplificateur est agencé pour fournir au VCO un signal de rétroaction (12, 13) qui est en phase avec la phase du signal de sortie provenant du VCO, et **en ce que** le second amplificateur (120) comprend des éléments réactifs pour créer un gain d'amplificateur comme une fonction de fréquence qui est telle que l'amplitude du signal de sortie provenant du circuit oscillant (100) est constante sur une plage de fréquences opérationnelles du circuit oscillant, le second amplificateur (120) étant agencé pour fournir au VCO (105) ledit signal de rétroaction (12, 13) à destination du résonateur (115) du VCO.

2.  Circuit oscillant (100) selon la revendication 1, dans lequel le second amplificateur (120) comprend un premier coupleur (125), le premier coupleur (125) étant agencé pour conserver la phase du signal de rétroaction (12, 13) provenant du second amplificateur (120) au VCO (105) en phase avec le signal de sortie provenant du VCO (105).

3.  Circuit oscillant (100) selon la revendication 1 ou 2, comprenant un second coupleur (128), par l'intermédiaire duquel le second amplificateur (120) est connecté pour recevoir le signal de sortie (10, 11) provenant du VCO, ledit second coupleur (128) étant agencé pour commander la puissance du signal de sortie (10, 11) provenant du VCO (105) à destination du second amplificateur (120).

4.  Circuit oscillant (100) selon n'importe laquelle des revendications 1 à 3, dans lequel le VCO (105) est un VCO Colpitts.

5.  Circuit oscillant (100) selon n'importe laquelle des revendications 1 à 3, dans lequel le VCO (105) est un VCO à couplage transversal.

100

105

VCO

110

Amp. 1

120

Out

Amp. 2

115

Resonator

Out(VCO)

Fig. 1

200

105

VCO

110

Amp. 1

115

Resonator

125

Coupler 1

Amp. 2 → Out

120

Out(VCO)

Fig. 2

Fig. 3

FIG. 4

EP 2 636 145 B1

Oscillation frequencies

$Z$

$Z_{max}$
$Z_{max}/2$

$\Delta f$

$f_r$

$f$

FIG. 5b

$C_{total}$

$R$

412

FIG. 5a

FIG. 6

FIG. 7

FIG. 8

FIG. 9

EP 2 636 145 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2006035372 A1